# FASCICULE DE BREVET EUROPEEN

(11) **EP 2 978 005 B1**
(45) Date de publication et mention de la délivrance du brevet: **17.05.2017**
(21) Numéro de dépôt: 14178544.4
(22) Date de dépôt: 25.07.2014
(51) Int. Cl.: H01H 9/54, H02M 1/34, H02H 9/00, H02H 7/22

(54) **Dispositif de coupure de courant sur une ligne de transmission**
Stromunterbrechungsvorrichtung auf einer Übertragungsleitung
Current cut-off device on a transmission line

(43) Date de publication de la demande: 27.01.2016
(73) Titulaire: General Electric Technology GmbH, 5400 Baden (CH)
(72) Inventeur: Berard, David, 69100 Villeurbanne (FR); Yang, Yang, 69100 Villeurbanne (FR)
(74) Mandataire: Brevalex

(56) Documents cités:
- WO-A1-2011/057675
- CN-A- 103 219 699
- FR-A1- 2 985 082

## Description

### Domaine technique et art antérieur

L'invention concerne un dispositif de coupure de courant sur une ligne de transmission.

Le courant que l'on souhaite couper est, préférentiellement, un courant continu ou alternatif d'intensité élevée qui est présent sur des lignes de transmission et/ou de distribution de tension élevée, typiquement supérieure à 50kVCC (cas du courant continu) ou à 50kVeff (cas du courant alternatif). De façon plus générale, l'invention s'applique également à la coupure de courant sur des lignes de transmission et/ou de distribution sous tension de moindre valeur que les valeurs mentionnées ci-dessus. Le temps de coupure du courant doit être très bref, typiquement de l'ordre de quelques millisecondes.

La Demanderesse a déposé, en date du 23 Décembre 2011, sous le N° d'enregistrement national 2 985 082, une demande de brevet français intitulée « Dispositif disjoncteur mécatronique et procédé de déclenchement associé et application à la coupure de courant continu élevé ».

La demande de brevet FR 2 985 082 divulgue un dispositif disjoncteur mécatronique apte à couper un courant qui circule sur un moyen de transmission de l'énergie électrique. Le dispositif disjoncteur mécatronique comprend trois branches en parallèle, à savoir une branche principale dans laquelle circule le courant qui doit être coupé, une branche auxiliaire et un limiteur de tension principal également appelé parafoudre. La branche auxiliaire comprend elle-même, en parallèle, au moins une sous-branche de temporisation et au moins une sous-branche d'armement.

La présence de la ou des sous-branche(s) de temporisation conduit à la réalisation d'une branche auxiliaire dont le nombre de composants est élevé. Par ailleurs, les composants électroniques de puissance utilisés dans la ou les sous-branches de temporisation ne sont pas des composants standards. En effet, il est nécessaire que le temps d'ouverture (« Turn-off time » en langue anglaise) de ces composants soit extrêmement faible. Cette exigence technique conduit à l'utilisation de composants ayant un coût élevé.

L'invention ne présente pas cet inconvénient.

### Exposé de l'invention

L'invention concerne un dispositif de coupure de courant sur une ligne de transmission, le dispositif comprenant trois branches électriques montées en parallèle parmi lesquelles une branche principale dans laquelle circule le courant qui doit être coupé, une branche auxiliaire et une branche de limitation de tension, la branche principale comprenant au moins une cellule de coupure à élément semi-conducteur montée en série avec au moins un interrupteur-sectionneur mécanique, la cellule de coupure à élément semi-conducteur comprenant au moins un élément semi-conducteur apte à être commandé en ouverture ou en fermeture monté en parallèle avec un limiteur de tension, la branche auxiliaire comprenant au moins un ensemble constitué d'un condensateur monté en parallèle avec une résistance, ledit ensemble étant monté en série avec au moins un thyristor, le dispositif comprenant des moyens de commande aptes à commander une ouverture de l'élément semi-conducteur de la cellule de coupure à élément semi-conducteur et une ouverture de l'interrupteur-sectionneur mécanique.

Les moyens de commande comprennent, en outre, des moyens aptes à commander une mise en conduction du thyristor de la branche auxiliaire à un instant supérieur ou égal à l'instant où, le courant étant éteint dans l'élément semi-conducteur de la cellule de coupure à élément semi-conducteur, le courant qui circule dans le ou les limiteur(s) de tension atteint la valeur du courant qui circule dans la ligne de transmission.

Selon un premier mode de réalisation de l'invention, les moyens de commande comprennent :
- des moyens aptes à appliquer une commande d'ouverture à l'interrupteur-sectionneur mécanique à un instant t₀,
- des moyens aptes à appliquer la commande d'ouverture à l'élément semi-conducteur de la cellule de coupure à élément semi-conducteur à un instant t₁ supérieur à l'instant t₀, de sorte qu'un courant qui parcourt ledit élément semi-conducteur diminue jusqu'à extinction et qu'un courant qui parcourt le ou les limiteur(s) de tension augmente jusqu'à atteindre la valeur du courant qui circule dans la ligne de transmission, et
- des moyens aptes à appliquer une commande de mise en conduction du thyristor de la branche auxiliaire à un instant t₂ supérieur ou égal à l'instant où le courant qui circule dans le ou les limiteur(s) de tension atteint la valeur du courant qui circule dans la ligne de transmission.

Selon un perfectionnement du premier mode de réalisation de l'invention, le dispositif comprend en outre :
- des moyens de commande aptes à appliquer, à un instant qui précède l'instant t₀, une commande d'ouverture préliminaire à l'élément semi-conducteur de la cellule de coupure de la branche principale,
- des moyens aptes à mesurer une charge des condensateurs de stockage montés en parallèle du thyristor de la branche auxiliaire dès lors que la commande d'ouverture préliminaire est appliquée à l'élément semi-conducteur de la cellule de coupure de la branche principale, et
- des moyens aptes à autoriser, à l'instant t₀, l'application de la commande d'ouverture à l'interrupteur-sectionneur mécanique si une mesure de la charge des condensateurs de stockage est conforme à une valeur de charge prédéterminée.

Selon un deuxième mode de réalisation de l'invention, au moins une cellule de coupure à élément semi-conducteur supplémentaire ayant un pouvoir de coupure supérieur au pouvoir de coupure de la cellule de coupure à élément semi-conducteur est placée en parallèle de la cellule de coupure à élément semi-conducteur.

Par « pouvoir de coupure » d'une cellule de coupure, l'homme du métier entend la capacité de la cellule de coupure à couper des courants d'amplitude élevée. Le pouvoir de coupure d'une cellule de coupure est ainsi d'autant plus élevé que l'amplitude du courant coupé par la cellule est grande.

Dans une première variante du deuxième mode de réalisation de l'invention, la cellule de coupure à élément semi-conducteur supplémentaire comprend au moins un limiteur de tension monté en parallèle de l'élément semi-conducteur qu'elle contient. Ce limiteur de tension est dimensionné pour pouvoir être parcouru par un courant dont l'intensité est égale à l'intensité du courant coupé par la cellule de coupure supplémentaire.

Dans une deuxième variante du deuxième mode de réalisation de l'invention, la deuxième cellule de coupure ne comprend pas de limiteur de tension qui lui soit propre et ce sont le ou les limiteurs de tension de la cellule de coupure à élément semi-donducteur qui sont dimensionnés pour pouvoir être parcouru(s) par un courant dont l'intensité est égale à l'intensité du courant coupé par la cellule de coupure supplémentaire.

Selon le deuxième mode de réalisation de l'invention, les moyens de commande comprennent :
- des moyens aptes à appliquer une commande d'ouverture à l'élément semi-conducteur de la cellule de coupure à élément semi-conducteur à un instant tₐ,
- des moyens aptes à appliquer une commande d'ouverture à l'interrupteur-sectionneur mécanique et une commande de fermeture à l'élément semi-conducteur de la cellule de coupure à élément semi-conducteur supplémentaire à un instant t_{b} supérieur à tₐ, de sorte que l'élément semi-conducteur de la cellule de coupure à élément semi-conducteur supplémentaire devienne conducteur,

- des moyens aptes à appliquer une commande d'ouverture de l'élément semi-conducteur de la cellule de coupure à élément semi-conducteur supplémentaire à un instant t_{c} supérieur à t_{b}, de sorte qu'un courant qui parcourt l'élément semi-conducteur de la cellule de coupure à élément semi-conducteur supplémentaire diminue jusqu'à extinction et qu'un courant qui parcourt le ou les limiteur(s) de tension augmente jusqu'à atteindre la valeur du courant qui circule dans la ligne de transmission, et
- des moyens aptes à appliquer une commande de mise en conduction du thyristor de la branche auxiliaire à un instant t_{d} supérieur ou égal à l'instant où le courant qui circule dans le ou les limiteur(s) de tension atteint la valeur du courant qui circule dans la ligne de transmission.

Selon un perfectionnement du deuxième mode de réalisation de l'invention, les moyens de commande comprennent des moyens aptes à appliquer une commande d'ouverture préliminaire à l'élément semi-conducteur de la cellule de coupure de la branche principale à l'instant tₐ et le dispositif comprend, en outre :
- des moyens qui mesurent une charge de condensateurs de stockage montés en parallèle du thyristor de la branche auxiliaire dès lors que la commande d'ouverture préliminaire est appliquée à l'élément semi-conducteur de la cellule de coupure de la branche principale, et
- des moyens aptes à autoriser l'application de la commande d'ouverture à l'interrupteur-sectionneur mécanique si une mesure de la charge des condensateurs de stockage est conforme à une valeur de charge prédéterminée.

Le dispositif de coupure de courant de l'invention ne comprend pas de sous-branche de temporisation. Un avantage de l'invention est de réduire la taille et le coût du dispositif de coupure de courant ainsi que d'augmenter la fiabilité de celui-ci.

Le courant coupé qui circule dans la branche principale peut être le courant nominal ou un courant de toute autre intensité, par exemple, un courant d'intensité supérieure à celle du courant nominal et qui résulte de l'apparition d'un défaut dans le matériel électrique auquel le dispositif de coupure de courant appartient.

### Brève description des figures

D'autres caractéristiques et avantages de l'invention apparaîtront à la lecture de la description qui va suivre faite en référence aux figures jointes, parmi lesquelles :
- Les figures 1A et 1B représentent une première variante d'un dispositif de coupure de courant selon un premier mode de réalisation de l'invention ;
- La figure 2 représente une deuxième variante d'un dispositif de coupure de courant selon le premier mode de réalisation de l'invention ;
- La figure 3 représente une troisième variante d'un dispositif de coupure de courant selon le premier mode de réalisation de l'invention ;
- La figure 4 représente une quatrième variante d'un dispositif de coupure de courant selon le premier mode de réalisation de l'invention ;
- Les figures 5A-5C illustrent le phénomène de coupure de courant tel qu'il survient, en fonction du temps, dans les circuits représentés sur les figures 1A-4 ;
- La figure 6 représente un dispositif de coupure de courant selon un deuxième mode de réalisation de l'invention ;
- Les figures 7A-7D illustrent le phénomène de coupure de courant tel qu'il survient, en fonction du temps, dans le circuit représenté sur la figure 6 ;

Les figures 8A-8D représentent, à titre d'exemples non limitatifs, différentes variantes de branches auxiliaires compatibles des différents modes de réalisation de l'invention.

Sur toutes les figures, les mêmes références désignent les mêmes éléments.

### Exposé détaillé de modes de réalisation de l'invention

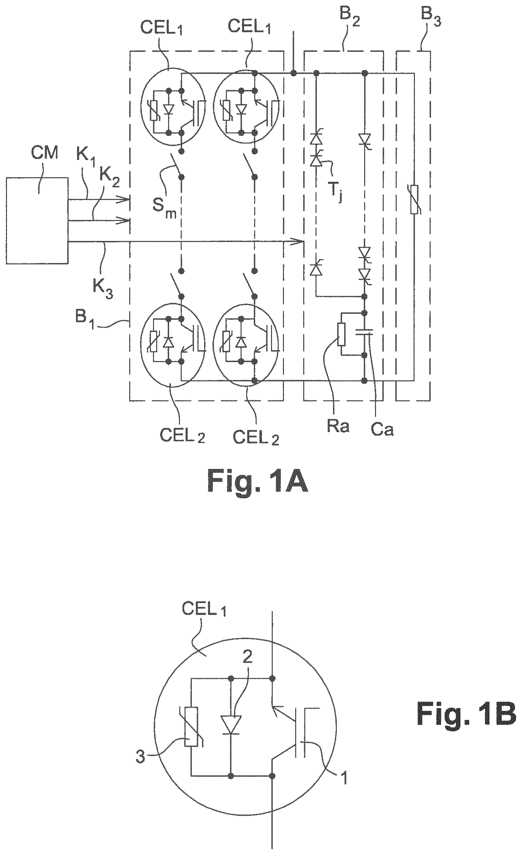

Les figures 1A et 1B représentent une première variante d'un dispositif de coupure de courant selon le premier mode de réalisation de l'invention.

La figure 1A représente les éléments électriques essentiels qui constituent le dispositif de coupure de courant dans son entier et la figure 1B représente une vue de détail d'un des éléments représentés sur la figure 1A.

Le dispositif de coupure de courant comprend trois branches en parallèle B₁, B₂, B₃ et un circuit de commande CM. Les branches se composent d'une branche principale B₁ dans laquelle circule le courant qui doit être coupé, d'une branche auxiliaire B₂ et d'une branche B₃ constituée d'un parafoudre.

A titre d'exemple non limitatif, la branche principale B₁ comprend deux sous-branches en parallèle, chaque sous-branche comprenant au moins un interrupteur-sectionneur mécanique Sₘ et deux cellules de coupure à élément semi-conducteur CEL₁, CEL₂. De façon préférentielle, chaque cellule de coupure CELᵢ (i=1, 2) est placée à une extrémité de la sous-branche et le ou les sectionneurs mécaniques sont placés entre les cellules de coupure. Chaque cellule de coupure à élément semi-conducteur CELᵢ (i=1, 2) comprend, par exemple, un transistor bipolaire à grille isolée 1, également connu sous l'appellation transistor IGBT (IGBT pour « Insulated-Gate Bipolar Transistor »), une diode 2 et un limiteur de tension 3 (cf. Figure 1B). La diode 2 est montée en anti-parallèle du transistor 1 et le limiteur de tension 3 est monté en parallèle du transistor 1. Les cellules de coupure CEL₁, CEL₂ sont montées tête-bêche de part et d'autre des interrupteurs-sectionneurs mécaniques Sₘ.

Dans l'exemple représenté par la figure 1A, la branche principale comprend deux sous-branches. De façon plus générale cependant, la branche principale peut n'être constituée que d'une seule branche ou comprendre N sous-branches en parallèle (N≥2).

La branche auxiliaire B₂ comprend au moins un condensateur Ca en parallèle avec au moins une résistance Ra et au moins deux sous-ensembles de thyristors Tⱼ en cascade. Les deux sous-ensembles de thyristors sont montés en parallèle et tête-bêche. L'ensemble constitué de la résistance Ra et du condensateur Ca est monté en série avec les deux sous-ensembles de thyristors. De façon connue en soi, chaque thyristor de la branche auxiliaire comprend une électronique de commande (non représentée sur les figures) qui est montée en parallèle du thyristor. Cette électronique de commande comprend des condensateurs de stockage qui participent au processus de commande des thyristors.

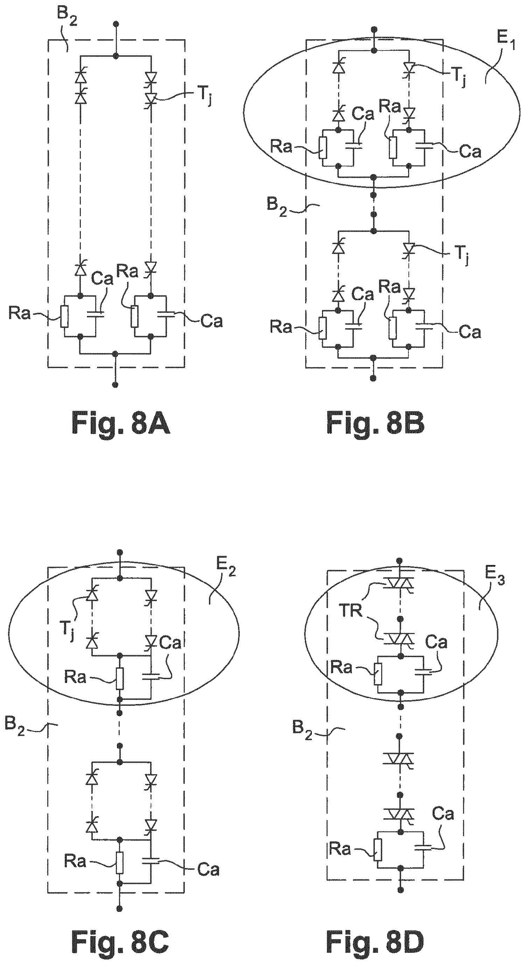

La branche auxiliaire B₂ représentée en figure 1A est un exemple de réalisation de branche auxiliaire. D'autres exemples de réalisation de la branche auxiliaire B₂ sont donnés ci-dessous, en référence aux figures 8A-8D.

Le dispositif de coupure de courant selon la première variante du premier mode de réalisation de l'invention qui est représentée par les figures 1A et 1B est avantageusement apte à conduire un courant continu ou un courant alternatif. La présence des diodes dans la branche principale et des composants montés tête-bêche dans les branches principale et auxiliaire permet en effet la conduction d'un courant continu circulant dans l'un ou l'autre sens ou la conduction d'un courant alternatif dont les alternances changent de sens. Selon l'application souhaitée, l'homme du métier saura en conséquence apprécier la nécessité qu'il y a à conserver ou non la présence de diodes et de composants montés tête-bêche.

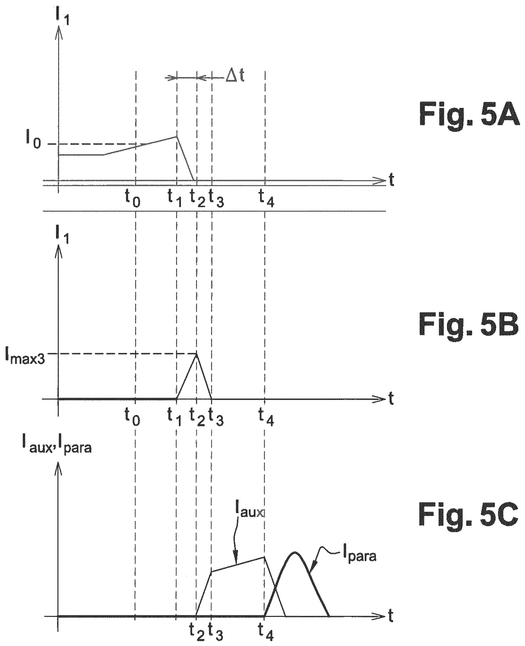

Le fonctionnement du dispositif représenté sur les figures 1A-1B va maintenant être décrit, en référence aux figures 5A-5D.

Sur les figures 5A-5D, le processus de coupure de courant est représenté dans le cas où l'apparition d'un défaut fait croître le courant I₁ qui parcourt la branche principale jusqu'à une valeur de seuil I₀ dont la détection déclenche la coupure. De façon plus générale, l'homme du métier comprendra que le processus de coupure peut être déclenché à tout moment, dès lors qu'une instruction de déclenchement en est donnée, même sans apparition de défaut, quelle que soit la valeur du courant.

En fonctionnement normal, les transistors IGBT 1 conduisent : le courant IL à couper passe par la branche principale B₁ et ni la branche auxiliaire B₂, ni le parafoudre (branche B₃) ne conduisent. Dans la suite de la description du premier mode de réalisation de l'invention, le courant qui circule dans le ou les transistors IGBT de la branche principale est noté I₁ et le courant qui circule dans le ou les limiteurs de tension est noté I₃.

A un instant t₀, le courant I₁ atteint une valeur I₀ et le circuit de commande CM envoie une commande d'ouverture simultanée K₁ à tous les interrupteurs-sectionneurs mécaniques Sₘ. A un instant t₁ supérieur à t₀, le circuit de commande CM envoie ensuite une commande d'ouverture simultanée K₂ à tous les transistors IGBT. La différence de temps qui sépare l'instant t₁ de l'instant t₀ est choisie en fonction de l'intensité du courant à couper. Plus l'intensité du courant à couper est élevée, plus la durée qui sépare l'instant t₁ de l'instant t₀ est choisie longue pour une même valeur de la capacité du condensateur Ca. A titre d'exemple non limitatif, un mode de réalisation de l'invention est tel que, pour une valeur de la capacité du condensateur Ca égale à 34µF et une valeur crête du courant à couper égale à 8kA, la différence de temps qui sépare l'instant t₁ de l'instant t₀ est égale à 250µs.

D'un point de vue théorique, les instants t₀ et t₁ pourraient être confondus. Si tel était le cas, cependant, la capacité du condensateur Ca atteindrait des valeurs trop élevées.

A partir de l'instant t₁, le courant I₁ diminue dans les IGBT jusqu'à extinction et le courant I₃ qui parcourt les limiteurs de tension 3 augmente jusqu'à atteindre une valeur de courant Iₘₐₓ₃ qui est égale au courant qui circule dans la ligne de transmission (cf. Figure 5B).

A un instant t₂ supérieur ou égal à l'instant où le courant qui circule dans le ou les limiteur(s) de tension atteint la valeur du courant qui circule dans la ligne de transmission, tous les thyristors de la branche auxiliaire sont mis à l'état passant à l'aide d'une commande K₃ délivrée par le circuit de commande CM. Durant l'intervalle de temps Δt qui sépare l'instant t₂ de l'instant t₁, les capacités de stockage montées en parallèle des thyristors de la branche auxiliaire se chargent.

Un courant Iₐᵤₓ parcourt alors les thyristors de la branche auxiliaire (cf. Figure 5C). Le courant Iₐᵤₓ croît. A un instant t₃ supérieur à l'instant t₂, les interrupteurs-sectionneurs mécaniques Sₘ sont à l'état électriquement ouvert.

La durée entre l'instant t₁ où l'ordre est donné aux interrupteurs-sectionneurs mécaniques de s'ouvrir et l'instant t₃ est une caractéristique propre aux interrupteurs-sectionneurs mécaniques. Deux cas se présentent alors, selon que l'instant t₂ est inférieur ou supérieur à l'instant t₃.

Dans le cas où l'instant t₂ est inférieur à l'instant t₃ (cas représenté sur les figures 5A-5C), les thyristors sont fermés avant que les interrupteurs-sectionneurs mécaniques Sₘ ne soient placés à l'état électriquement ouvert. Un courant de plus en plus important circule alors dans la branche auxiliaire. Le condensateur Ca se charge et la tension monte à ses bornes. La présence de la capacité permet de temporiser la montée en tension aux bornes du parafoudre (la valeur de la capacité est choisie, à cette fin, en fonction de la valeur du courant de la branche principale que l'on souhaite interrompre). Dès lors qu' à un instant t₄ la tension aux bornes du parafoudre atteint la tension de conduction du parafoudre, ce dernier commence à conduire et le courant Iₚₐᵣₐ qui parcourt le parafoudre croît, entraînant ainsi la chute du courant dans la branche auxiliaire. Par la suite, de façon connue en soi, le courant dans le parafoudre se stabilise et diminue jusqu'à extinction totale et la tension aux bornes de la branche principale se stabilise à la tension réseau.

Dans le cas où l'instant t₂ est supérieur à l'instant t₃, les thyristors sont fermés après que les interrupteurs-sectionneurs mécaniques sont placés à l'état électriquement ouvert. La valeur de la capacité du condensateur Ca peut alors avantageusement être choisie inférieure à celle qui est choisie lorsque l'instant t₂ est inférieur à l'instant t₃.

Selon un perfectionnement de l'invention, le procédé de coupure est précédé d'un test préliminaire des thyristors de la branche auxiliaire.

Ce test s'effectue comme suit. A un instant t₀-δt qui précède l'instant t₀, la durée δt pouvant être, par exemple, égale à quelques micro-secondes, une commande d'ouverture est appliquée aux transistors IGBT. L'ouverture des transistors IGBT conduit à l'apparition d'une tension aux bornes de chaque transistor IGBT. Cette tension s'applique alors aux bornes des condensateurs de stockage qui sont en parallèle des thyristors de la branche auxiliaire. Il en résulte une charge progressive des condensateurs de stockage. La charge des condensateurs de stockage est alors mesurée et, s'il est constaté que cette charge s'effectue correctement (i.e. la tension aux bornes des condensateurs de stockage atteint une valeur de seuil prédéterminée en un temps requis), les thyristors de la branche auxiliaire sont considérés comme en état de fonctionner. L'ordre d'ouverture des interrupteurs-sectionneurs mécaniques est envoyé à l'instant t₀, comme indiqué précédemment.

Par contre, si la charge des condensateurs de stockage ne s'effectue pas correctement (i.e. la tension aux bornes des condensateurs de stockage n'atteint pas une valeur de seuil prédéterminée en un temps requis), les thyristors de la branche auxiliaire ne sont pas considérés comme en état de fonctionner et aucun ordre d'ouverture n'est envoyé aux interrupteurs-sectionneurs mécaniques.

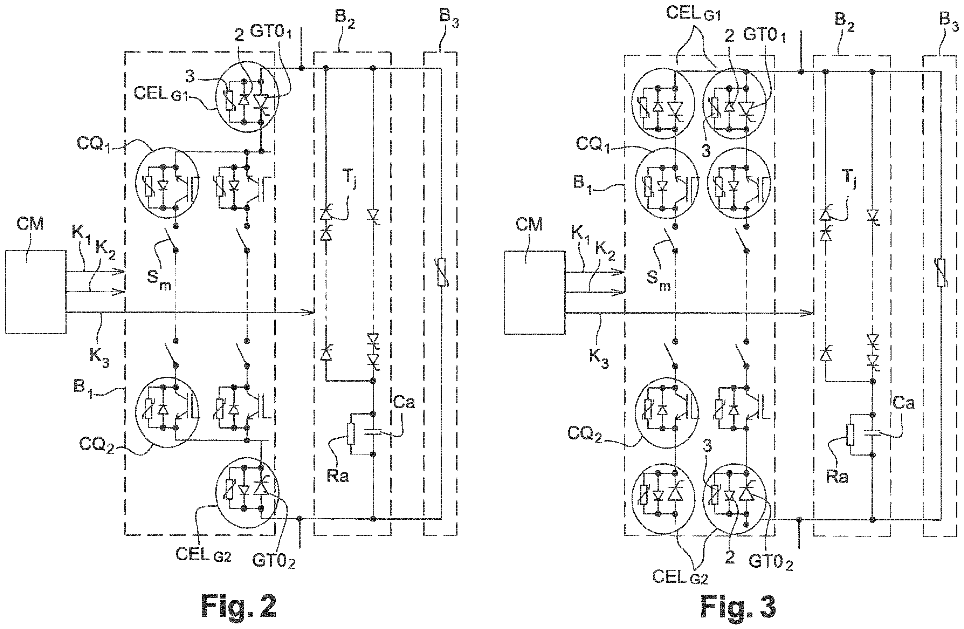

La figure 2 représente une deuxième variante d'un dispositif de coupure de courant selon le premier mode de réalisation de l'invention.

A titre d'exemple non limitatif, la branche principale comprend deux cellules de coupure à thyristor à extinction par la gachette CEL_{G1}, CEL_{G2}.

Chaque cellule de coupure à thyristor à extinction par la gachette CEL_{Gi} (i=1, 2) comprend au moins un thyristor à extinction par la gachette GTOᵢ (GTO pour « Gate Turn-Off »), une diode 2 et un limiteur de tension 3. La diode 2 est montée en anti-parallèle du thyristor à extinction par la gachette GTOᵢ. Chaque cellule CEL_{Gi} (i=1, 2) est placée, de façon préférentielle, à une extrémité de la branche principale. Les deux cellules CEL_{G1} et CEL_{G2} sont montées tête-bêche, de part et d'autre d'une pluralité de sous-branches en parallèle, chaque sous-branche comprenant au moins un interrupteur-sectionneur mécanique Sₘ et deux cellules d'équilibrage de courant CQᵢ montées tête-bêche, chaque cellule d'équilibrage de courant étant placée à une extrémité de la sous-branche.

Les cellules d'équilibrage de courant CQᵢ (i=1, 2) comprennent les mêmes composants que les cellules de coupure CELᵢ (i=1, 2) de la première variante décrite ci-dessus. Les transistors IGBT qui participent aux cellules d'équilibrage ne sont toutefois pas utilisés ici pour la coupure du courant, mais à seule fin d'équilibrer le courant qui circule dans les différentes sous-branches en parallèle de la branche principale.

Les remarques relatives à la circulation des courants continu et alternatif faites précédemment en référence au dispositif de coupure de la première variante s'appliquent également pour le dispositif de coupure de courant de la deuxième variante.

Il en est de même du processus de coupure représenté sur les figures 5A-5C qui s'applique également au dispositif représenté en figure 2.

Ainsi, le dispositif de commande CM délivre-t-il successivement une commande K₁ d'ouverture des interrupteurs-sectionneurs mécaniques à un instant t₀, une commande K₂ d'ouverture des thyristors à extinction par la gâchette de la branche principale à un instant t₁ et une commande K₃ de fermeture des thyristors de la branche auxiliaire à un instant t₂.

La figure 3 représente une troisième variante d'un dispositif de coupure de courant selon le premier mode de réalisation de l'invention.

A titre d'exemple non limitatif, la branche principale B₁ comprend deux sous-branches en parallèle, chaque sous-branche comprenant au moins un interrupteur-sectionneur mécanique Sₘ et deux cellules de coupure à thyristors à extinction par la gachette CEL_{G1} et CEL_{G2} montées tête-bêche de part et d'autre d'interrupteurs-sectionneurs mécaniques Sₘ. De façon préférentielle, chaque cellule de coupure CEL_{Gi} (i=1, 2) est placée à une extrémité de la sous-branche et le ou les sectionneurs mécaniques sont placés entre les cellules de coupure. Chaque cellule de coupure CEL_{Gi} (i=1, 2) comprend au moins un thyristor à extinction par la gachette GTOᵢ, une diode 2 et un limiteur de tension 3. La diode 2 est montée en anti-parallèle du (des)thyristor(s) à extinction par la gachette et le limiteur de tension 3 est monté en parallèle de la diode 2.

Des cellules d'équilibrage de courant CQᵢ (i=1, 2) sont placées entre les cellules de coupure CEL_{Gi} (i=1, 2) et les interrupteurs-sectionneurs mécaniques Sₘ. Chaque cellule d'équilibrage de courant comprend un transistor IGBT qui n'intervient pas dans le processus de coupure.

Dans l'exemple représenté en figure 3, la branche principale comprend deux sous-branches. De façon plus générale cependant, dans cette variante de l'invention, la branche principale contient N sous-branches en parallèle (N≥2).

Les remarques relatives à la circulation des courants continu et alternatif faites précédemment, en référence au dispositif de coupure de la première variante, s'appliquent également pour le dispositif de coupure de courant de la troisième variante.

De même que précédemment, le fonctionnement du processus de coupure mis en oeuvre par le dispositif représenté sur la figure 3 s'illustre à l'aide des figures 5A-5C. Ainsi, le dispositif de commande CM délivre-t-il successivement une commande d'ouverture des interrupteurs-sectionneurs mécaniques K₁ à un instant t₀, une commande d'ouverture des thyristors à extinction par la gachette de la branche principale K2 à un instant t₁ et une commande de fermeture K3 des thyristors de la branche auxiliaire à un instant t₂.

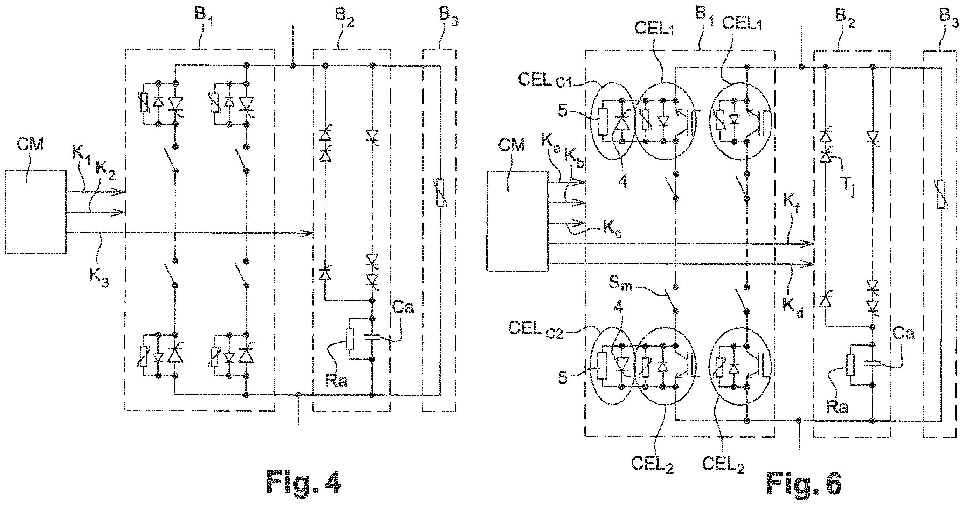

La figure 4 représente une quatrième variante d'un dispositif de coupure de courant selon le premier mode de réalisation de l'invention.

La quatrième variante correspond globalement à la première variante, la seule différence étant que les transistors IGBT du dispositif de la première variante sont remplacés ici par des thyristors GTO.

Le fonctionnement du processus de coupure mis en oeuvre par le dispositif représenté sur la figure 4 s'illustre également à l'aide des figures 5A-5C. Ainsi, le dispositif de commande CM délivre-t-il successivement une commande K₁ d'ouverture simultanée des interrupteurs-sectionneurs mécaniques à un instant t₀, une commande K₂ d'ouverture simultanée des thyristors à extinction par la gachette de la branche principale à un instant t₁ et une commande K₃ de fermeture simultanée des thyristors de la branche auxiliaire à un instant t₂. Les remarques précédentes relatives aux courant continu et alternatif s'appliquent également pour la quatrième variante du dispositif de coupure.

La figure 6 représente un dispositif de coupure de courant selon un deuxième mode de réalisation de l'invention.

Le deuxième mode de réalisation de l'invention correspond, de fait, à un perfectionnement de la première variante du premier mode de réalisation.

Dans certaines applications, le pouvoir de coupure des transistors IGBT n'est pas suffisant. Pour répondre à cette insuffisance, le deuxième mode de réalisation de l'invention prévoit, en parallèle d'au moins une cellule de coupure munie d'au moins un transistor IGBT, la présence d'au moins une cellule de coupure supplémentaire CEL_{Ci} (i=1, 2) ayant un pouvoir de coupure supérieur à celui de la cellule de coupure CELᵢ munie du transistor IGBT.

Une cellule de coupure CEL_{Ci} (i=1, 2) est constituée, par exemple, d'au moins un thyristor à extinction par la gâchette 4 monté en parallèle avec une électronique de commande 5. Dans une première variante du deuxième mode de réalisation de l'invention, l'électronique de commande 5 comprend au moins un limiteur de tension dimensionné pour conduire le courant susceptible d'être coupé par le thyristor à extinction par la gâchette 4. Dans une deuxième variante du deuxième mode de réalisation, l'électronique de commande 5 ne comprend pas de limiteur de tension qui lui soit propre et ce sont le ou les limiteurs de tension de la cellule CELᵢ qui sont dimensionnés pour conduire le courant susceptible d'être coupé par le thyristor à extinstion par la gâchette 4.

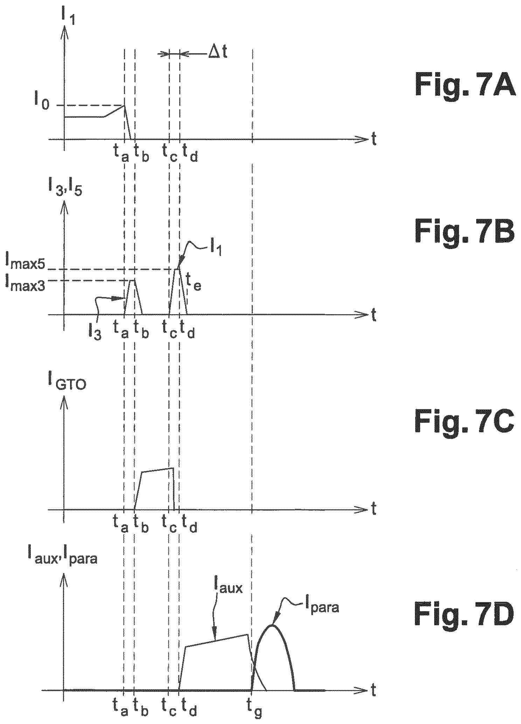

Les figures 7A-7D illustrent le procédé de coupure du courant qui circule dans la branche principale selon le deuxième mode de réalisation de l'invention. Dans la suite de la description du deuxième mode de réalisation de l'invention, le courant qui circule dans le ou les transistors IGBT de la branche principale est noté I₁ et le courant qui circule dans le ou les limiteurs de tension est noté I₃ ou I₅.

Comme mentionné précédemment en référence aux figures 5A-5D, le processus de coupure de courant représenté sur les figures 7A-7D correspond au cas où l'apparition d'un défaut fait croître le courant I₁ qui circule dans le ou les transistors IGBT jusqu'à une valeur de seuil I₀ dont la détection déclenche la coupure. De manière plus générale cependant, le processus de coupure peut être déclenché à tout moment, dès lors qu'une instruction de déclenchement en est donnée, même sans l'apparition d'un défaut et quelle que soit la valeur du courant qui parcourt les transistors IGBT.

Lorsque le courant I₁ atteint, à un instant tₐ, une valeur prédéterminée I₀, une commande d'ouverture Kₐ est envoyée par le circuit de commande CM à tous les transistors IGBT. Le courant dans les transistors IGBT diminue jusqu'à extinction et le courant I₃ dans le ou les limiteur(s) de tension en parallèle des transistors IGBT augmente jusqu'à atteindre une valeur maximale Iₘₐₓ₃.

A un instant t_{b} supérieur à tₐ, une commande d'ouverture K_{b} est envoyée à tous les interrupteurs-sectionneurs mécaniques Sₘ et, simultanément, une commande de fermeture K_{c} est envoyée aux thyristors à extinction par la gâchette 4. Les thyristors à extinction par la gâchette 4 deviennent alors conducteurs. Puis, à un instant t_{c} supérieur à t_{b}, une commande d'ouverture K_{d} est envoyée aux thyristors à extinction par la gâchette 4. Le courant I_{GTO} dans les thyristors 4 diminue jusqu'à extinction et un courant I₅ augmente dans le ou les limiteurs de tension jusqu'à atteindre la valeur du courant Iₘₐₓ₅ qui circule dans la ligne de transmission.

A un instant t_{d} supérieur ou égal à l'instant où le courant qui circule dans le ou les limiteur(s) de tension atteint la valeur du courant qui circule dans la ligne de transmission, une commande Kₑ délivrée par le circuit de commande CM met tous les thyristors de la branche auxiliaire à l'état passant.

Durant l'intervalle de temps Δt qui sépare l'instant t_{d} de l'instant t_{c}, les condensateurs de stockage montés en parallèle des thyristors de la branche auxiliaire se chargent.

Un courant Iₐᵤₓ parcourt alors les thyristors de la branche auxiliaire. A un instant tₑ supérieur à l'instant t_{d}, les interrupteurs-sectionneurs mécaniques Sₘ sont à l'état électriquement ouvert.

La durée entre l'instant t_{b} où l'ordre est donné aux interrupteurs-sectionneurs mécaniques de s'ouvrir et l'instant tₑ est une caractéristique propre aux interrupteurs-sectionneurs mécaniques. Deux cas se présentent alors, selon que l'instant t_{d} est inférieur ou supérieur à l'instant tₑ.

Dans le cas où l'instant t_{d} est inférieur à l'instant tₑ, les thyristors de la branche auxiliaire sont fermés avant que les interrupteurs-sectionneurs mécaniques ne soient placés à l'état électriquement ouvert. Un courant de plus en plus important circule alors dans la branche auxiliaire. La capacité Ca se charge et la tension monte à ses bornes. La présence de la capacité permet de temporiser la montée en tension aux bornes du parafoudre (la valeur de la capacité est choisie, à cette fin, en fonction de la valeur du courant de la branche principale que l'on souhaite interrompre). Dès lors qu'à un instant t_{f} la tension aux bornes du parafoudre atteint la tension de conduction du parafoudre, ce dernier commence à conduire et le courant Iₚₐᵣₐ qui parcourt le parafoudre croît, entraînant ainsi la chute du courant dans la branche auxiliaire. Par la suite, de façon connue en soi, le courant dans le parafoudre se stabilise et diminue jusqu'à extinction totale et la tension aux bornes de la branche principale se stabilise à la tension réseau.

Dans le cas où l'instant t_{d} est supérieur à l'instant tₑ, les thyristors sont fermés après que les interrupteurs-sectionneurs mécaniques sont placés à l'état électriquement ouvert. La valeur de la capacité Ca peut alors avantageusement être choisie inférieure à la valeur choisie lorsque l'instant t_{d} est grand. Au plus t_{d} est grand, au plus la valeur de la capacité Ca est faible.

Selon le deuxième mode de réalisation de l'invention, il est possible de faire le test préliminaire des thyristors de la branche auxiliaire entre les instants tₐ et t_{b}. La durée qui sépare les instants tₐ et t_{b} est typiquement égale, au minimum, à 10µs qui est une durée suffisante pour effectuer le test. A l'instant tₐ où les IGBT sont ouverts sous l'effet de la commance Kₐ, une tension est créée aux bornes des IGBT, tension qui charge les condensateurs de stockage montés en parallèle des thyristors de la branche auxiliaire. Une mesure de cette charge est alors effectuée. Si la charge des condensateurs de stockage s'effectue normalement, le procédé suit son cours avec la mise en conduction des cellules CEL_{Ci} (i=1, 2). Sinon, le procédé est interrompu.

Dans les exemples de réalisation de l'invention mentionnés ci-dessus, l'élément semi-conducteur des cellules de coupure CEL₁ est un transistor IGBT ou un thyristor à extinction par la gâchette. L'invention concerne également le cas où, par exemple, l'élément semi-conducteur des cellules de coupure CEL₁ est un thyristor à silicium, ou un thyristor à carbure de silicium, ou un thyristor à nitrure de gallium. Un tel thyristor présente avantageusement une très faible tension à ses bornes quand il est passant (thyristor fermé). Ainsi, une très faible consommation est-elle garantie lorsqu'on l'utilise. Un autre avantage des thyristors à carbure de silicium ou à nitrure de gallium est le fait qu'ils peuvent assurer une fréquence d'ouverture/fermeture élevée qui contribue à accélérer le processus de coupure du courant.

Afin d'obtenir les mêmes avantages que ceux mentionnés ci-dessus (faible consommation, rapidité), les thyristors de la branche auxiliaire peuvent également être des thyristors à silicium et/ou des thyristors à carbure de silicium et/ou des thyristors à nitrure de gallium.

Les figures 8A-8D représentent, à titre d'exemples non limitatifs, différentes variantes de branche auxiliaire compatibles des différents modes de réalisation de l'invention.

En référence à la figure 8A, la branche B₂ comprend une première branche et une deuxième branche montées en parallèle. La première branche est constituée d'un premier sous-ensemble de thyristors Tj montés en série électrique avec au moins un condensateur Ca lui-même monté en parallèle avec au moins une résistance Ra et la deuxième branche est constituée d'un deuxième sous-ensemble de thyristors Tj montés en série électrique avec au moins un autre condensateur Ca lui-même monté en parallèle avec au moins une autre résistance Ra. Les thyristors du deuxième sous-ensemble de thyristors sont montés tête-bêche par rapport aux thyristors du premier sous-ensemble. Chaque sous-ensemble de thyristors Tj comprend au moins un thyristor.

En référence à la figure 8B, la branche B₂ est constituée d'au moins un sous-ensemble E₁ conforme à la branche B₂ de la figure 8A prise dans son entier.

En référence à la figure 8C, la branche B₂ est constituée d'au moins sous-ensemble E₂ conforme à la branche B₂ de la figure 1A prise dans son entier.

En référence à la figure 8D, la branche B₂ est constituée d'au moins un sous-ensemble E₃ constitué d'au moins un TRIAC TR monté en série avec au moins un ensemble constitué d'au moins une résistance Ra montée en parallèle avec au moins un condensateur Ca.

## Revendications

1. Dispositif de coupure de courant qui circule sur une ligne de transmission, le dispositif comprenant trois branches électriques montées en parallèle parmi lesquelles une branche principale (B₁) dans laquelle circule le courant qui doit être coupé, une branche auxiliaire (B₂) et une branche de limitation de tension (B₃), la branche principale comprenant au moins une cellule de coupure à élément semi-conducteur (CEL₁, CEL_{G1}) montée en série avec au moins un interrupteur-sectionneur mécanique (Sₘ), la cellule de coupure à élément semi-conducteur (CEL₁, CEL_{C1}) comprenant au moins un élément semi-conducteur (1, 4) apte à être commandé en ouverture ou en fermeture monté en parallèle avec un limiteur de tension (5, 3), la branche auxiliaire (B₂) comprenant au moins un ensemble constitué d'au moins un condensateur (Ca) monté en parallèle avec au moins une résistance (Ra), ledit ensemble étant monté en série avec au moins un thyristor, le dispositif comprenant des moyens de commande aptes à commander une ouverture de l'élément semi-conducteur de la cellule de coupure à élément semi-conducteur (CEL₁, CEL_{G1}) et une ouverture de l'interrupteur-sectionneur mécanique (Sₘ), **caractérisé en ce que** les moyens de commande comprennent, en outre, des moyens aptes à commander une mise en conduction du thyristor de la branche auxiliaire (B₂) à un instant supérieur ou égal à l'instant où, le courant étant éteint dans l'élément semi-conducteur de la cellule de coupure à élément semi-conducteur, le courant qui circule dans le ou les limiteur(s) de tension atteint la valeur du courant (IL) qui circule dans la ligne de transmission.

2. Dispositif de coupure de courant sur une ligne de transmission selon la revendication 1, dans lequel les moyens de commande comprennent :
- des moyens aptes à appliquer une commande d'ouverture (K₁) à l'interrupteur-sectionneur mécanique (Sₘ) à un instant t₀,
- des moyens aptes à appliquer une commande d'ouverture (K₂) à l'élément semi-conducteur de la cellule de coupure à élément semi-conducteur à un instant t₁ supérieur à l'instant t₀, de sorte qu'un courant qui parcourt ledit élément semi-conducteur diminue jusqu'à extinction et qu'un courant qui parcourt le ou les limiteur(s) de tension augmente jusqu'à atteindre la valeur du courant qui circule dans la ligne de transmission, et
- des moyens aptes à appliquer une commande de mise en conduction du thyristor de la branche auxiliaire à un instant t₂ supérieur ou égal à l'instant où le courant qui circule dans le ou les limiteur(s) de tension atteint la valeur du courant (IL) qui circule dans la ligne de transmission.

3. Dispositif selon la revendication 2, dans lequel, lorsque la branche principale (B₁) comprend au moins deux sous-branches en parallèle, chaque sous-branche comprend au moins une cellule d'équilibrage de courant apte à équilibrer le courant entre les différentes sous-branches en parallèle.

4. Dispositif selon la revendication 3, dans lequel une cellule d'équilibrage de courant est constituée d'un élément semi-conducteur apte à conduire le courant monté en parallèle avec un circuit de limitation de tension.

5. Dispositif selon la revendication 4, dans lequel l'élément semi-conducteur est un transistor IGBT.

6. Dispositif selon la revendication 2, dans lequel chaque cellule de coupure à élément semi-conducteur est montée en série avec au moins deux sous-branches, chaque sous-branche comprenant au moins un interrupteur-sectionneur mécanique et/ou une cellule d'équilibrage de courant apte à équilibrer les courants entre les sous-branches.

7. Dispositif selon l'une quelconque des revendications 2 à 6 et qui comprend, en outre :
- des moyens de commande aptes à appliquer, à un instant qui précède l'instant t₀, une commande d'ouverture préliminaire à l'élément semi-conducteur de la cellule de coupure de la branche principale,
- des moyens aptes à mesurer une charge de condensateurs de stockage montés en parallèle du thyristor de la branche auxiliaire dès lors que la commande d'ouverture préliminaire est appliquée à l'élément semi-conducteur de la cellule de coupure de la branche principale, et
- des moyens aptes à autoriser, à l'instant t₀, l'application de la commande d'ouverture à l'interrupteur-sectionneur mécanique (Sₘ) si une mesure de la charge des condensateurs de stockage est conforme à une valeur de charge prédéterminée.

8. Dispositif selon l'une quelconque des revendications 2 à 7, dans lequel l'élément semi-conducteur est un transistor IGBT.

9. Dispositif selon l'une quelconque des revendications 2 à 7, dans lequel l'élément semi-conducteur est un thyristor à extinction par la gachette.

10. Dispositif selon l'une quelconque des revendications 2 à 7, dans lequel l'élément semi-conducteur est un thyristor à silicium ou un thyristor carbure de silicium ou un thyristor à Nitrure de Gallium.

11. Dispositif selon la revendication 1, dans lequel la branche principale (B₁) comprend au moins une cellule de coupure à élément semi-conducteur supplémentaire (CEL_{C1}) placée en parallèle de la cellule de coupure à élément semi-conducteur (CEL₁), ladite cellule de coupure à élément semi-conducteur supplémentaire (CEL_{C1}) ayant un pouvoir de coupure supérieur à un pouvoir de coupure de la cellule de coupure à élément semi-conducteur (CEL₁).

12. Dispositif selon la revendication 11, dans lequel la cellule de coupure à élément semi-conducteur supplémentaire (CEL_{C1}) comprend au moins un limiteur de tension (5) monté en parallèle du limiteur de tension de la cellule de coupure à élément semi-conducteur (CEL₁).

13. Dispositif selon la revendication 11 ou 12, dans lequel les moyens de commande comprennent :
- des moyens aptes à appliquer une commande d'ouverture (Kₐ) à l'élément semi-conducteur de la cellule de coupure à élément semi-conducteur à un instant tₐ,
- des moyens aptes à appliquer une commande d'ouverture (K_{b}) à l'interrupteur-sectionneur mécanique (Sₘ) et une commande de fermeture (K_{c}) à l'élément semi-conducteur de la cellule de coupure à élément semi-conducteur supplémentaire (CEL_{C1}) à un instant t_{b} supérieur à tₐ, de sorte que l'élément semi-conducteur de la cellule de coupure à élément semi-conducteur supplémentaire devienne conducteur,
- des moyens aptes à appliquer une commande d'ouverture (K_{d}) de l'élément semi-conducteur de la cellule de coupure à élément semi-conducteur supplémentaire à un instant t_{c} supérieur à t_{b}, de sorte qu'un courant qui parcourt l'élément semi-conducteur de la cellule de coupure à élément semi-conducteur supplémentaire diminue jusqu'à extinction et qu'un courant qui parcourt le ou les limiteur(s) de tension augmente jusqu'à atteindre la valeur du courant qui circule dans la ligne de transmission, et
- des moyens aptes à appliquer une commande de mise en conduction (Ke) du thyristor de la branche auxiliaire à un instant t_{d} supérieur ou égal à l'instant où le courant qui circule dans le ou les limiteur(s) de tension atteint la valeur du courant (IL) qui circule dans la ligne de transmission.

14. Dispositif selon la revendication 11, dans lequel les moyens de commande comprennent des moyens de commande aptes à appliquer une commande d'ouverture préliminaire à l'élément semi-conducteur de la cellule de coupure de la branche principale à l'instant tₐ et qui comprend, en outre :
- des moyens qui mesurent une charge de condensateurs de stockage montés en parallèle du thyristor de la branche auxiliaire dès lors que la commande d'ouverture préliminaire est appliquée à l'élément semi-conducteur de la cellule de coupure de la branche principale, et
- des moyens aptes à autoriser l'application de la commande d'ouverture à l'interrupteur-sectionneur mécanique (Sₘ) si une mesure de charge des condensateurs de stockage est conforme à une valeur de charge prédéterminée.

15. Dispositif selon l'une quelconque des revendications 11 à 14, dans lequel l'élément semi-conducteur que comprend la cellule de coupure à élément semi-conducteur supplémentaire est un thyristor à extinction par la gachette.

16. Dispositif selon la revendication 11 ou 12, dans lequel l'élément semi-conducteur que comprend la cellule de coupure à élément semi-conducteur supplémentaire est un thyristor à silicium ou un thyristor à carbure de silicium ou un thyristor à nitrure de gallium.

17. Dispositif selon l'une quelconque des revendications 15 ou 16, dans lequel l'élément semi-conducteur de la cellule de coupure à élément semi-conducteur est un transistor IGBT.

18. Dispositif selon l'une quelconque des revendications précédentes dans lequel, le thyristor de la branche auxiliaire est un thyristor à silicium ou un thyristor à carbure de silicium ou un thyristor à nitrure de gallium.

## Patentansprüche

1. Stromunterbrechungsvorrichtung für Strom, der auf einer Übertragungsleitung fließt, wobei die Vorrichtung drei Stromzweige enthält, die parallel geschaltet sind, darunter ein Hauptzweig (B₁), in welchem der zu unterbrechende Strom fließt, ein Nebenzweig (B₂) und ein Spannungsbegrenzungszweig (B₃), wobei der Hauptzweig zumindest eine Halbleiterelement-Schaltzelle (CEL₁, CEL_{G1}) aufweist, die in Reihe mit zumindest einem mechanischen Lasttrennschalter (Sₘ) geschaltet ist, wobei die Halbleiterelement-Schaltzelle (CEL₁, CEL_{G1}) zumindest ein Halbleiterelement (1, 4) enthält, das dazu geeignet ist, auf- bzw. zugesteuert zu werden und das parallel mit einem Spannungsbegrenzer (52, 3) geschaltet ist, wobei der Nebenzweig (B₂) zumindest eine Einheit enthält, die aus zumindest einem parallel mit zumindest einem Widerstand (Ra) geschalteten Kondensator (Ca) besteht, wobei die genannte Einheit in Reihe mit zumindest einem Thyristor geschaltet ist, wobei die Vorrichtung Steuereinrichtungen enthält, die dazu geeignet sind, ein Öffnen des Halbleiterelements der Halbleiterelement-Schaltzelle (CEL₁, CEL_{G1}) und ein Öffnen des mechanischen Lasttrennschalters (Sₘ) zu steuern, **dadurch gekennzeichnet, dass** die Steuereinrichtungen ferner Einrichtungen enthält, die dazu geeignet sind, ein Einschalten des Thyristors des Nebenzweigs (B₂) zu einem Zeitpunkt zu steuern, der später oder gleich einem Zeitpunkt ist, an dem bei in dem Halbleiterelement der Halbleiterelement-Schaltzelle ausgeschaltetem Strom der in dem bzw. den Spannungsbegrenzer(n) fließende Strom den Wert des Stroms (I_{L}) erreicht, der in der Übertragungsleitung fließt.

2. Stromunterbrechungsvorrichtung an einer Übertragungsleitung nach Anspruch 1, wobei die Steuereinrichtungen enthalten:
- Einrichtungen, die dazu geeignet sind, zu einem Zeitpunkt to einen Öffnungsbefehl (K₁) an den mechanischen Lasttrennschalter (Sₘ) zu erteilen,
- Einrichtungen, die dazu geeignet sind, zu einem Zeitpunkt t₁, der später als der Zeitpunkt to ist, einen Öffnungsbefehl (K₂) an das Halbleiterelement der Halbleiterelement-Schaltzelle zu erteilen, so dass ein durch das Halbleiterelement fließender Strom bis zum Erlöschen abnimmt und ein durch den bzw. die Spannungsbegrenzer fließender Strom zunimmt, bis er den Wert des Stroms erreicht, der in der Übertragungsleitung fließt, und
- Einrichtungen, die dazu geeignet sind, einen Einschaltbefehl des Thyristors des Nebenzweigs zu einem Zeitpunkt t₂ zu erteilen, der später oder gleich einem Zeitpunkt ist, an dem der in dem bzw. den Spannungsbegrenzer(n) fließende Strom den Wert des Stroms (I_{L}) erreicht, der in der Übertragungsleitung fließt.

3. Vorrichtung nach Anspruch 2, wobei dann, wenn der Hauptzweig (B₁) zumindest zwei parallel geschaltete Unterzweige enthält, jeder Unterzweig zumindest eine Stromabgleichzelle enthält, die dazu geeignet ist, den Strom zwischen den verschiedenen, parallel geschalteten Unterzweigen abzugleichen.

4. Vorrichtung nach Anspruch 3, wobei eine Stromabgleichzelle aus einem Halbleiterelement besteht, das dazu geeignet ist, den Strom zu leiten und mit einer Spannungsbegrenzungsschaltung parallel geschaltet ist.

5. Vorrichtung nach Anspruch 4, wobei das Halbleiterelement ein IGBT-Transistor ist.

6. Vorrichtung nach Anspruch 2, wobei jede Halbleiterelement-Schaltzelle in Reihe mit zumindest zwei Unterzweigen geschaltet ist, wobei jeder Unterzweig zumindest einen mechanischen Lasttrennschalter und/oder eine Stromabgleichzelle enthält, die dazu geeignet ist, die Ströme zwischen den Unterzweigen abzugleichen.

7. Vorrichtung nach einem der vorangehenden Ansprüche 2 bis 6, ferner enthaltend:
- Einrichtungen, die dazu geeignet sind, zu einem Zeitpunkt, der dem Zeitpunkt to vorausgeht, einen vorläufigen Öffnungsbefehl an das Halbleiterelement der Schaltzelle des Hauptzweigs zu erteilen,
- Einrichtungen, die dazu geeignet sind, eine Ladung von parallel geschalteten Speicherkondensatoren des Thyristors des Nebenzweigs dann zu messen, wenn der vorläufige Öffnungsbefehl an das Halbleiterelement der Schaltzelle des Hauptzweigs erteilt ist, und
- Einrichtungen, die dazu geeignet sind, zum Zeitpunkt to die Erteilung des Öffnungsbefehls an den mechanischen Lasttrennschalter (Sₘ) zu gestatten, wenn eine Messung der Ladung der Speicherkondensatoren konform mit einem vorbestimmten Ladungswert ist.

8. Vorrichtung nach einem der Ansprüche 2 bis 7, wobei das Halbleiterelement ein IGBT-Transistor ist.

9. Vorrichtung nach einem der Ansprüche 2 bis 7, wobei das Halbleiterelement ein GTO-Thyristor ist.

10. Vorrichtung nach einem der Ansprüche 2 bis 7, wobei das Halbleiterelement ein Silizium-Thyristor oder ein Siliciumcarbid-Thyristor oder ein Galliumnitrid-Thyristor ist.

11. Vorrichtung nach Anspruch 1, wobei der Hauptzweig (B₁) zumindest eine zusätzliche Halbleiterelement-Schaltzelle (CEL_{C1}) enthält, die parallel mit der Halbleiterelement-Schaltzelle (CEL₁) geschaltet ist, wobei die zusätzliche Halbleiterelement-Schaltzelle (CEL_{C1}) ein Schaltvermögen hat, das höher als ein Schaltvermögen der Halbleiterelement-Schaltzelle (CEL₁) ist.

12. Vorrichtung nach Anspruch 11, wobei die zusätzliche Halbleiterelement-Schaltzelle (CEL_{C1}) zumindest einen Spannungsbegrenzer (5) enthält, der mit dem Spannungsbegrenzer der Halbleiterelement-Schaltzelle (CEL₁) parallel geschaltet ist.

13. Vorrichtung nach Anspruch 11 oder 12, wobei die Steuereinrichtungen enthalten:
- Einrichtungen, die dazu geeignet sind, zu einem Zeitpunkt to einen Öffnungsbefehl (Kₐ) an das Halbleiterelement der Halbleiterelement-Schaltzelle zu erteilen,
- Einrichtungen, die dazu geeignet sind, zu einem Zeitpunkt t_{b}, der später als tₐ ist, einen Öffnungsbefehl (K_{b}) an den mechanischen Lasttrennschalter (Sₘ) zu erteilen und einen Schließbefehl (K_{c}) an das Halbleiterelement der zusätzlichen Halbleiterelement-Schaltzelle (CEL_{C1}) zu erteilen, so dass das Halbleiterelement der zusätzlichen Halbleiterelement-Schaltzelle leitend wird,
- Einrichtungen, die dazu geeignet sind, zu einem Zeitpunkt t_{c}, der später als der Zeitpunkt t_{b} ist, einen Öffnungsbefehl (K_{d}) an das Halbleiterelement der zusätzlichen Halbleiterelement-Schaltzelle zu erteilen, so dass ein durch das Halbleiterelement der zusätzlichen Halbleiterelement-Schaltzelle fließender Strom bis zum Erlöschen abnimmt und ein durch den bzw. die Spannungsbegrenzer fließender Strom zunimmt, bis er den Wert des Stroms erreicht, der in der Übertragungsleitung fließt, und
- Einrichtungen, die dazu geeignet sind, einen Einschaltbefehl (Ke) des Thyristors des Nebenzweigs zu einem Zeitpunkt t_{d} zu erteilen, der später oder gleich dem Zeitpunkt ist, an dem der in dem bzw. den Spannungsbegrenzer(n) fließende Strom den Wert des Stroms (I_{L}) erreicht, der in der Übertragungsleitung fließt.

14. Vorrichtung nach Anspruch 11, wobei die Steuereinrichtungen Steuereinrichtungen enthalten, die dazu geeignet sind, zum Zeitpunkt tₐ einen vorläufigen Öffnungsbefehl an das Halbleiterelement der Schaltzelle des Hauptzweigs zu erteilen,
die ferner enthält:
- Einrichtungen, die eine Ladung von parallel geschalteten Speicherkondensatoren des Thyristors des Nebenzweigs dann messen, wenn der vorläufige Öffnungsbefehl an das Halbleiterelement der Schaltzelle des Hauptzweigs erteilt ist, und
- Einrichtungen, die dazu geeignet sind, die Erteilung des Öffnungsbefehls an den mechanischen Lasttrennschalter (Sₘ) zu gestatten, wenn eine Messung der Ladung der Speicherkondensatoren konform mit einem vorbestimmten Ladungswert ist.

15. Vorrichtung nach einem der Ansprüche 11 bis 14, wobei das Halbleiterelement, das die zusätzliche Halbleiterelement-Schaltzelle enthält, ein GTO-Thyristor ist.

16. Vorrichtung nach Anspruch 11 oder 12, wobei das Halbleiterelement, das die zusätzliche Halbleiterelement-Schaltzelle enthält, ein Silizium-Thyristor oder ein Siliciumcarbid-Thyristor oder ein Galliumnitrid-Thyristor ist.

17. Vorrichtung nach einem der Ansprüche 15 oder 16, wobei das Halbleiterelement der Halbleiterelement-Schaltzelle ein IGBT-Transistor ist.

18. Vorrichtung nach einem der vorangehenden Ansprüche, wobei der Thyristor des Nebenzweigs ein Silizium-Thyristor oder ein Siliciumcarbid-Thyristor oder ein Galliumnitrid-Thyristor ist.

## Claims

1. A breaker device for interrupting current flowing on a transmission line, the device comprising three electrical branches connected in parallel, namely: a main branch (B₁) in which the current to be interrupted flows; an auxiliary branch (B₂); and a voltage limiter branch (B₃) ; the main branch comprising at least one semi-conductor breaker cell (CEL₁, CEL_{G1}) connected in series with at least one mechanical interrupter/disconnector (Sₘ), the semi-conductor breaker cell (CEL₁, CEL_{C1}) including at least one semi-conductor element (1, 4) that is suitable for being commanded to open or close and that is connected in parallel with a voltage limiter (5, 3), the auxiliary branch (B₂) comprising at least one assembly that is constituted by at least one capacitor (Ca) connected in parallel with at least one resistor (Ra), said assembly being connected in series with at least one thyristor, the device further comprising control means that are suitable for commanding opening of the semi-conductor element of the semi-conductor breaker cell (CEL₁, CEL_{G1}) and opening of the mechanical interrupter/disconnector (Sₘ), the device being **characterized in that** the control means further comprise means that are suitable for acting, once the current is interrupted in the semi-conductor element of the semi-conductor breaker cell, to command the thyristor of the auxiliary branch (B₂) to be put into a conductive state at an instant that is after or at the instant at which the current flowing in the voltage limiter(s) reaches the value of the current (I_{L}) that is flowing in the transmission line.

2. A breaker device for interrupting current on a transmission line, according to claim 1wherein the control means comprise:
• means that are suitable for applying an opening command (K₁) to the mechanical interrupter/disconnector (Sₘ) at an instant to;
• means that are suitable for applying an opening command (K₂) to the semi-conductor element of the semi-conductor breaker cell at an instant t₁ that is after the instant t₀, such that a current passing through said semi-conductor element decreases until it is zero, and such that a current passing through the voltage limiter(s) increases until it reaches the value of the current that is flowing in the transmission line; and
• means that are suitable for applying a command for putting the thyristor of the auxiliary branch in a conductive state at an instant t₂ that is after or at the instant at which the current flowing in the voltage limiter(s) reaches the value of the current (I_{L}) that is flowing in the transmission line.

3. A device according to claim 2, wherein, when the main branch (B₁) comprises at least two parallel sub-branches, each sub-branch includes at least one current-balancing cell that is suitable for balancing the current between the various parallel sub-branches.

4. A device according to claim 3, wherein a current-balancing cell is constituted by a semi-conductor element that is suitable for conducting the current and that is connected in parallel with a voltage limiting circuit.

5. A device according to claim 4, wherein the semi-conductor element is an IGBT.

6. A device according to claim 2, wherein each semi-conductor breaker cell is connected in series with at least two sub-branches, each sub-branch comprising at least one mechanical interrupter/disconnector and/or at least one current-balancing cell that is suitable for balancing the currents between the sub-branches.

7. A device according to any one of claims 2 to 6 and which further comprises:
• control means that are suitable, at an instant that precedes the instant t₀, for applying a preliminary opening command to the semi-conductor element of the breaker cell of the main branch;
• means that are suitable, when the preliminary opening command is applied to the semi-conductor element of the breaker cell of the main branch, for measuring charge in storage capacitors connected in parallel with the thyristor of the auxiliary branch; and
• means that are suitable for allowing the opening command to be applied to the mechanical interrupter/disconnector (Sₘ) at the instant t₀, if a measurement of the charge of the storage capacitors matches a predetermined charge value.

8. A device according to any one of claims 2 to 7, wherein the semi-conductor element is an IGBT.

9. A device according to any one of claims 2 to 7, wherein the semi-conductor element is a GTO thyristor.

10. A device according to any one of claims 2 to 7, wherein the semi-conductor element is a silicon thyristor or a silicon carbide thyristor or a gallium nitride thyristor.

11. A device according to claim 1, wherein the main branch (B₁) includes at least one additional semi-conductor breaker cell (cell) that is placed in parallel with the semi-conductor breaker cell (CEL₁), said additional semi-conductor breaker cell (CEL_{C1}) having breaking capacity that is greater than the breaking capacity of the semi-conductor breaker cell (CEL₁).

12. A device according to claim 11, wherein the additional semi-conductor breaker cell (CEL_{C1}) includes at least one voltage limiter (5) connected in parallel with the voltage limiter of the semi-conductor breaker cell (CEL₁).

13. A device according to claim 11 or claim 12, wherein the control means comprise:
• means that are suitable for applying an opening command (Kₐ) to the semi-conductor element of the semi-conductor breaker cell at an instant tₐ;
• means that are suitable for applying an opening command (K_{b}) to the mechanical interrupter/disconnector (Sₘ) and a closing command (K_{c}) to the semi-conductor element of the additional semi-conductor breaker cell (CEL_{C1}) at an instant t_{b} that is after the instant tₐ, such that the semi-conductor element of the additional semi-conductor breaker cell becomes conductive;
• means that are suitable for applying an opening command (K_{d}) to the semi-conductor element of the additional semi-conductor breaker cell at an instant t_{c} that is after the instant t_{b}, such that a current passing through the semi-conductor element of the additional semi-conductor breaker cell decreases until it is zero, and such that a current passing through the voltage limiter(s) increases until it reaches the value of the current that is flowing in the transmission line; and
• means that are suitable for applying a command (Kₑ) for putting the thyristor of the auxiliary branch in a conductive state at an instant t_{d} that is after or at the instant at which the current flowing in the voltage limiter(s) reaches the value of the current (I_{L}) that is flowing in the transmission line.

14. A device according to claim 11, wherein the control means comprise control means that are suitable for applying a preliminary opening command to the semi-conductor element of the breaker cell of the main branch at the instant tₐ, and wherein the device further comprises:
• means that act when the preliminary opening command is applied to the semi-conductor element of the breaker cell of the main branch to measure charge in storage capacitors connected in parallel with the thyristor of the auxiliary branch; and
• means that are suitable for allowing the opening command to be applied to the mechanical interrupter/disconnector (Sₘ), if a measurement of the charge of the storage capacitors matches a predetermined charge value.

15. A device according to any one of claims 11 to 14, wherein the semi-conductor element of the additional semi-conductor breaker cell is a GTO thyristor.

16. A device according to claim 11 or claim 12, wherein the semi-conductor element of the additional semi-conductor breaker cell is a silicon thyristor or a silicon carbide thyristor or a gallium nitride thyristor.

17. A device according to claim 15 or claim 16, wherein the semi-conductor element of the semi-conductor breaker cell is an IGBT.

18. A device according to any preceding claim, wherein the thyristor of the auxiliary branch is a silicon thyristor or a silicon carbide thyristor or a gallium nitride thyristor.
